# EUROPEAN PATENT APPLICATION

(11) **EP 1 073 125 A2**
(43) Date of publication of application: **31.01.2001**
(21) Application number: 00104800.8
(22) Date of filing: 06.03.2000
(51) Int. Cl.: H01L 31/0216

(54) **Integrated semiconductor optic sensor device and corresponding manufacturing process**

(30) Priority: 28.07.1999 IT MI991680
(71) Applicant: STMicroelectronics S.r.l., 20041 Agrate Brianza (Milano) (IT)
(72) Inventor: Bordogna, Matteo, 20040 Bellusco (Milano) (IT); Laurin, Enrico, 20035 Lissone (Milano) (IT); Bernardi, Oreste, 20044 Bernareggio (Milano) (IT)
(74) Representative: Botti, Mario

(57) **Abstract**

The invention relates to a process for manufacturing a light sensor device in a standard CMOS process, including at least the following phases: implanting active areas on a semiconductor substrate to obtain at least a first integrated region of a corresponding photosensor; forming at least a stack of layers having different thickness and refractive index layers over the photosensor to provide interferential filters for the same photosensor. At least one of the above mentioned layers is formed by a trasparent metallic oxide having a high refraction index and a corresponding high dielectric constant.

In this manner, the design of interferential resonators is rendered more flexible making possible the use of a stack of layers including more than one high refraction index layer.

## Description

### Field of the Invention

The present invention relates to an integrated semiconductor optic sensor device having a desired spectral selectivity and obtained by a standard CMOS process.

The invention also relates to a process for manufacturing an optic sensor device by a standard CMOS process, including at least the following phases:
implanting active areas on a semiconductor substrate to obtain at least a first integrated region of a corresponding photosensor;
forming at least a stack of layers having different thickness and refractive index over said photosensor to provide an interferential filter for said photosensor.

One of the most inportant field of application of the invention is the process for manufacturing a matrix of integrated colour sensitive photosensors, for instance for colour images or colour television camera.

### Background Art

As is well known, optical light sensors based on semiconductor properties are widely used for several video image applications.

Various techniques may be used for optical to electrical conversion. One of the most effective is based on electron-hole generation due to the light absorption of a semiconductor reverse biased photodiode.

Since the final effect of the electron-hole generation doesn't represent the wavelength of the absorbed light in the optical range, this physical mechanism cannot distinguish different colours.

To implement colour sensitivity a series of coloured filters is generally provided between the light source and the photosensitive device.

This is usually implemented by a deposition of an organic coloured resin over the finished semiconductor photosensitive device. This resin stops by absorption all the unwanted colours of the incident light and transmits to the light sensor just the light wavelengths to be selected. In this manner the electric signal generated in the semiconductor device is correlated to the selected colour only.

In the case of colour selectivity used for CMOS video cameras, the photodiodes are integrated on silicon to form a bidimensional matrix. From the top view each diode looks squared. Each diode is electrically insulated from the other adjacent diodes by an isolation region, for instance field oxide.

To clearly detect colour images, the semiconductor matrix includes at least three different kind of staggered diodes, which are sensible to blue, green and red light respectively.

The main drawback of the photodiodes covered by the organic resin is due to the fact that the manufacturing process step for the resin deposition is a further process step and that the filter absorbs a portion of the incident light reducing the diode sensibility. Morover, long exposure to intense light, humidity, high temperature and ionising radiation may reduce the ability of the organic resins to stop the unwanted colours.

A better prior art solution for providing colour selectivity is disclosed in the European patent No. 0152353 which relates to method and device for obtaining a colour selecting effect based on the wave properties of the light. This method may be implemented during the semiconductor device manufacturing process instead than on the finished sensor.

Very briefly, this method provides the deposition of a stack of inorganic layers over the light sensor device. These layers have suitable thicknesses and indexes of refraction.

By a suitable definition of the stack structure it is possible to obtain the desired spectral transmission of the incident light toward the semiconductor sensor device.

Modulating the interference of the light waves reflected at all the layers interfaces of the stack it is possible to maximize or minimize the light intensity transmitted or reflected by the whole stack in pre-determined wavelength ranges, that is colours.

The method disclosed in the above cited European patent is based on the construction of an optical resonant semiconductor stack formed by the following layers: Monosilicon - Oxide - Polysilicon.

The incident light is reflected by the interface monosilicon/oxide and interferes with the light reflected by the other interface oxide/polysilicon.

The above disclosed method of wavelenght selection by interference determines a better reliability of the sensor, due to the degradation tendency of conventional organic resins. This better reliability is appreciated in those application fields wherein a high temperature or humidity is present, or in cases of high light exposure of the sensor, or even in presence of ionizing radiations.

Moreover, the interferential technique can be integrated in standard VLSI semiconductor processes without the need of a dedicated and separeted process and environment to apply colour selecting resins on the finished sensor.

As explained above, interferential stacks are formed by materials having a high and a low refraction index, respectively. Polysilicon, or amorfous silicon, is generally used as high refraction index material, while silicon dioxide is commonly used as low index material.

The use of Polysilicon leads to an intrinsic parasitic absorption of light that involves a consequent loss of a portion of the optical signal before it reaches the sensor.

This fact limits the use of the interferential method to the construction of simple resonators with one or very few layers of a very thin high index material, for instance few hundreds of Angstrom. This is a severe limitation on the large variety of possible transmission spectra theoretically obtained with the interferential method.

The aim of the present invention is that of preserving the interferential properties and avoiding absorption of light within the interferenrial stack.

A further object of the present invention is that of using a high refraction index layer having the highest possible transparency in order to improve the current interferential applications, such as video cameras, and to greatly widen the field of application of integrated interferential photodetectors.

A further aim of the invention is that of improving the spectral sensitivity of the photodetectors that is not available with the standard coloured resins or with interferential integrated stacks of known type that make use of the polysilicon layer.

A further aim of the invention is that of rendering more flexible the design of resonators by the possibility of making more complex interferential stacks with any number of high refraction index layers and low refraction index layers, thereby achieving a wide range of spectral transmission curves.

### Summary of the Invention

The solution idea behind the present invention is that of using a transparent metallic oxide having a high dielectric constant as the high refraction index layer of the multilayer interferential filter.

According to this solution idea, the invention relates to process for manufacturing a light sensor device in a standard CMOS process, including at least the following phases:
- implanting active areas on a semiconductor substrate to obtain at least a first integrated region of a corresponding photosensor;
- forming at least a stack of layers having different thickness and refractive index over said photosensor to provide an interferential filter for said photosensor;
   wherein:
- at least one of said layers is formed by a trasparent metallic oxide having a high refraction index.

In this manner, the design of interferential resonators is rendered more flexible making possible the use of a stack of layers including more than one high refraction index layer. This possibility wasn't currently available since non totally transparent high index materials, such as polysilicon, are currently used according to the teaching of the prior art solutions.

The features and advantages of the invention will become apparent from the following description of an embodiment thereof, given by way of non-limiting example with reference to the accompanying drawings.

### Brief Description of the Drawings

- Figure 1 is a schematic view of a vertical cross section of a semiconductor portion including a light sensor device manufactured according to the present invention;
- Figure 2 is a schematic view of a vertical cross section of a semiconductor portion including a light sensor device according to a further embodiment of the present invention;
- Figure 3 is a schematic view of a vertical cross section of a semiconductor portion at the beginning of the inventive manufacturing process;
- Figure 4 is a schematic view of a vertical cross section of a semiconductor portion during further process step of the manufacturing process according to the present invention;
- Figure 5 is a schematic view of a vertical cross section of a semiconductor portion including at least three photodiodes obtained with the manufacturing process according to the invention.

### Detailed Description

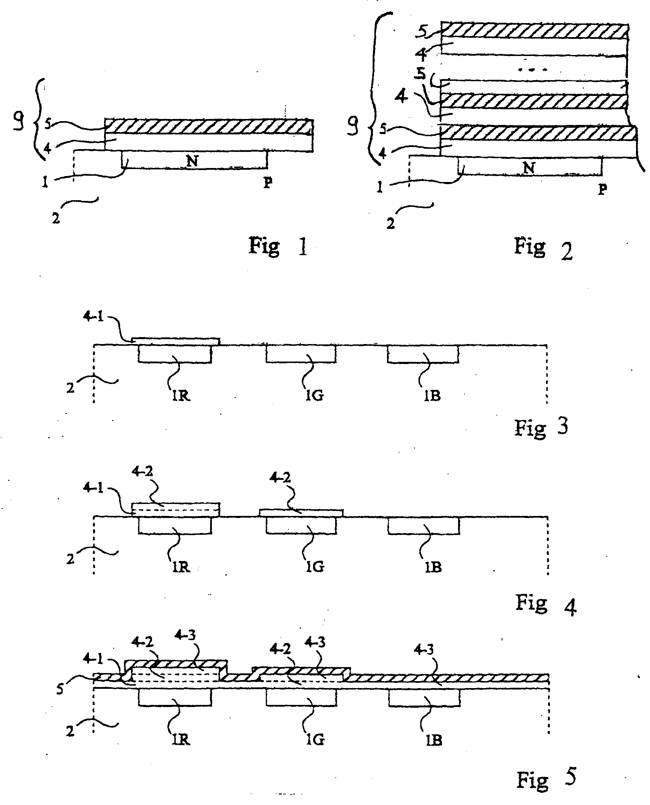

With reference to the drawing figures, generally and schematically shown in Figure 1 is a light sensor device 1 including an interferential coloured filter 9 according to the present invention.

The process steps and the structures described herein below do not form a complete process flow for manufacturing integrated circuits. In fact, this invention can be practised jointly with integrated circuit manufacturing techniques currently used in the art, and only those common process steps will be discussed herein as are necessary to an understanding of the invention.

The drawing figures which show cross-sections through a semiconductor wafer are not drawn to scale but rather to highlight major features of the invention.

The light sensor device 1 may be considered an integrated photodiode which is realized over a semiconductor substrate 2 region of a first conductivity type, for instance a P doped semiconductor region.

This semiconductor substrate 2 hosts other CMOS circuit components, which are realized according to a conventional and standard CMOS process flow.

The substrate 2 is formed by monocristalline silicon and will be disclosed hereinafter as a monosilicon substrate.

The photodiode 1 comprises a first region formed by the monocristalline silicon of the substrate and a second monocristalline region having a doping type, opposite to the substrate.

Over the region 1 there is a stack formed by a multilayer structure including:
- A low refractive index dielectric layer, such as a silicon oxide layer 4;
- a high refractive index layer 5, for instance a transparent metallic oxide having a high refraction index and a corresponding high dielectric constant.

For some applications it might be advisable to use a further and optional layer 6 formed by a silicon nitride layer.

The stack including the layers 4, 5 and 6 above monosilicon 1, presents different thicknesses and refractive indexes and represents the interferential filter 9.

The monosilicon and the trasparent metallic oxide layers 1, 5 have a high refraction index, while the silicon oxide layer 4 and the optional silicon nitride layer 6 have a low refraction index.

As known from EP 0152353, the thickness of the various layers must be defined to assure an anti-reflection effect and a filtering effect according to a specific light wavelength.

With specific reference to the examples of the Figures from 3 to 5, the process according to the present invention is now disclosed.

Figure 3 shows a monosilicon semiconductor portion 2 comprising three different diode cathode regions 1R, 1G, 1B, respectively. These regions will be sensible to Red, Green and Blue colours respectively.

These regions 1R, 1G, 1B are defined by a photolitografic process step that provided for a resist deposition and etching steps followed by a Source/Drain implantation of the diodes active areas uncovered by dielectric, as in a standard CMOS process.

According to the inventive process, silicon oxide layers having different thickness are deposited over these three regions 1R, 1G, 1B.

A first process step shown in Figure 3 provides for the deposition of a first oxide layer 4-1 just over the first cathode region 1R.

More specifically, a blanket oxide deposition is performed over the substrate 2 surface. Then a mask is provided to protect the area of the cathode region 1R where the Red photosensor must be formed. A subsequent oxide etching and resist mask removal clears the area out from region 1R.

A further process step is then performed to cover with a second oxide layer 4-2 the second cathode region 1G and the first oxide layer 4-1, as clearly shown in Figure 4.

A blanket oxide deposition is then performed over the semiconductor. A mask is provided to protect the area of the cathode regions 1R and 1G where the Red and the Green photosensors must be formed. A subsequent oxide etching and resist mask removal clears the area out from regions 1R and 1G.

The inventive process is proceeded with a further oxide deposition step to cover with a third oxide layer 4-3 the whole semiconductor portion shown in Figure 5.

Advantageously, this further oxide layer 4-3 is a protecting (undoped) dielectric layer, for instance a USG type layer, which is normally used as a first layer of premetal dielectric over a polysilicon layer. In standard Cmos processes the premetal dielectric (which is the insulator deposited before metal interconnections) is generally a stack of a first protecting dielectric, undoped and not planarizing, followed by a second planarizing dielectric (usually doped).

This third oxide layer is not etched between two adjacent photosensors. This allows obtaining a better planarized structure even if the USG oxide is a conformal layer.

Moreover, the thicknesses of the three oxide layers, by suitable deposition and etching phases, may be regulated according to the needs to bring the total thickness of the oxide stacks to a value multiple of the L/2. For instance, it's possible to obtain a layer thickness of nL/2, where n may be an integer number.

Then a cover layer 5 of a transparent metallic oxide having a high dielectric constant with a corresponding high refraction index, is deposited over the third oxide layer 4-3.

This layer 5 may be for instance a thin layer of titanium oxide (TiO₂) having a high transparency and high refraction index. Other similar materials may be suitable, for instance Ta₂O₅, having a high transparency and a high dielectric constant with a consequent high refraction index.

Refraction index of layer 5 has negligible imaginary component and so being highly transparent, causes a negligible signal loss due to absorption.

The transparency range includes the visible light as well as near Infra Red IR and near Ultra Violet UV wavelenghts.

In a further embodiment shown in figure 2 a light sensor device according to the invention is realised by implanting an active area on the semiconductor substrate in order to obtain at least a first integrated region of corresponding photosensor. Then at least a stack of layers having different thickness and refractive index is formed over this active area to provide an interferential filter for the photosensor.

Advantageously, according to the present invention, the high refraction index layer 5 of said stack are formed by a trasparent metallic oxide having a high refraction index.

The layer 5 can be obtained through two process steps. A first step provides a first deposition of a metallic titanium and a second process step provides for a thermal oxidation cycle in a controlled environment.

The physical properties of layer 5 are specifically advantageous in optical applications between 10E13 and 10E16 Hz.

It's also important to remark that layer 5 is not required to have specific electric properties to support electric fields since there is no need to apply any electric field to such a layer 5.

In the specific case of photodetector for video applications, this layer 5 of transparent metallic oxide improves the signal/noise ratio of the light sensor device with respect to the case in which it is made by polysilicon.

The inventive process may proceeded with a further deposition step of an optional silicon nitride layer 6.

An etching step is performed to remove the optional nitride layer 6, when it is present, and the transparent metallic oxide layer 5 out of the regions 1R, 1G and 1B. Then the photoresist mask is removed too.

The third USG oxide layer 4-3 is not etched thus avoiding a possible overetch and related field oxide consumption with a possible active areas widening on the CMOS circuitry and the consequent reduction of the insulating capability of the field oxide.

At this point the three stacks are defined over the diode sensors while the active areas of other CMOS circuitry integrated on the same semiconductor substrate 2 remain already covered by the protecting (undoped) dielectric layer 4-3 which is not removed by the last etching step.

A final process step is then performed to provide a metal dielectric deposition of a BPSG planarizing layer to provide the second planarizing dielectric layer.

The process according to the present invention allows an improved sensitivity of the sensors in interferential colour selecting sensors. This improved sensitivity holds at all optical wavelenghts, but becomes particularly evident for wavelenghts shorter than that of the yellow colour, which means green, blue, violet, near UV radiation down to at least 250 nm.

Another advantage of the inventive process, just given by the use of the transparent metallic oxide, is to allow more flexibility for the design of interferential resonators due to the possibility of using more than one, and not only very thin, high index layer, in order to get interferential transmission spectra of the desired shape (e.g. narrow integrated interferential pass band filters or any other pre-definited shape required for the desired application.

A related advantage is given by the possibility offered by the invention to realize a very wide range of spectral transmission curves since the interferential stack can be designed to fit to spectral stransmission shape needed having used a high index transparent material.

In conventional cases of use of organic resins the number of transmission bands associated with the various dyes is limited to the fixed spectral shapes of the dyes.

## Claims

1. A process for manufacturing an optic sensor device by a standard CMOS process, including at least the following phases:
- implanting active areas on a semiconductor substrate to obtain at least a first integrated region of a corresponding photosensor;
- forming at least a stack of layers having different thickness and refractive index over said photosensor to provide an interferential filter for said photosensor;
wherein:
- at least one (5) of said layers is formed by a trasparent metallic oxide having a high refraction index.

2. Process according to claim 1, wherein said at least one of said layers is a titanium oxide layer.

3. Process according to claim 1, wherein said at least one of said layers is a tantalium oxide layer.

4. Process according to claim 1, wherein a further deposition step of a silicon nitride layer is provided over said layer.

5. Process according to claim 1, wherein a second and a third integrated regions of corresponding photosensors are provided on said substrate and that said stack of layers cover said further regions.

6. Process according to claim 1, wherein said stack is a formed by a plurality of oxide layers (4) having a low refraction index each one covered by one layer (5) having a high refraction index.

7. An optic sensor device obtained by a standard CMOS process and including:
- at least a first integrated region on a semiconductor substrate for a corresponding photosensor;
- at least a stack of layers having different thickness and refractive index over said photosensor to provide an interferential filter of the desired spectral transmission shape for said photosensor;
wherein:
- At least one (5) of said layers is formed by a trasparent metallic oxide having a high refraction index.

8. An optic sensor device according to claim 8, wherein said at least one of layers is a titanium oxide layer.

9. An optic sensor device according to claim 8, wherein said at least one of layers is a tantalium oxide layer.
